(19) Europäisches Patentamt
European Patent Office
Office européen des brevets

(11) **EP 3 217 542 B1**

(12) **FASCICULE DE BREVET EUROPEEN**

(45) Date de publication et mention
de la délivrance du brevet:
**13.03.2019 Bulletin 2019/11**

(51) Int Cl.:
***H03B 5/12*** (2006.01)

(21) Numéro de dépôt: **17157728.1**

(22) Date de dépôt: **23.02.2017**

(54) **OSCILLATEUR COMMANDÉ EN TENSION**

SPANNUNGSGESTEUERTER OSZILLATOR

VOLTAGE-CONTROLLED OSCILLATOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.03.2016 FR 1651873**

(43) Date de publication de la demande:
**13.09.2017 Bulletin 2017/37**

(73) Titulaire: **COMMISSARIAT À L'ÉNERGIE
ATOMIQUE ET AUX
ÉNERGIES ALTERNATIVES
75015 Paris (FR)**

(72) Inventeurs:
• **MARTINEAU, Baudouin**
**38000 Grenoble (FR)**
• **GONZALEZ JIMENEZ, José-Luis**
**38340 Voreppe (FR)**
• **LARIE, Aurélien**
**38000 Grenoble (FR)**

(74) Mandataire: **Cabinet Beaumont
4, Place Robert Schuman
B.P. 1529
38025 Grenoble Cedex 1 (FR)**

(56) Documents cités:
**JP-A- 2014 183 371        US-A1- 2007 080 754
US-A1- 2009 134 947**

• **XU XIAO ET AL: "2.4-GHz band low-voltage
class-C PMOS VCO IC with amplitude feedback
loop", 2015 ASIA-PACIFIC MICROWAVE
CONFERENCE (APMC), IEEE, vol. 3, 6 décembre
2015 (2015-12-06), pages 1-3, XP032868859, DOI:
10.1109/APMC.2015.7413483 ISBN:
978-1-4799-8765-8 [extrait le 2016-02-18]**
• **YANG XIN ET AL: "A 0.3-V power supply
2.4-GHz-band Class-C VCO IC with amplitude
feedback loop in 65-nm CMOS", ANALOG
INTEGRATED CIRCUITS AND SIGNAL
PROCESSING, SPRINGER NEW YORK LLC, US,
vol. 81, no. 3, 10 juillet 2014 (2014-07-10), pages
583-591, XP035382914, ISSN: 0925-1030, DOI:
10.1007/S10470-014-0351-8 [extrait le 2014-07-10]**

## Description

Domaine

La présente demande concerne le domaine des oscillateurs commandés en tension, et plus particulièrement celui des oscillateurs à résonateur LC. Plus spécifiquement, la présente demande vise le domaine des oscillateurs à résonateur LC dits de classe C.

Exposé de l'art antérieur

Des oscillateurs commandés en tension sont utilisés dans de nombreuses applications, notamment pour générer des signaux radiofréquence ou signaux RF (c'est-à-dire des signaux de fréquence comprise dans la plage allant de 3 kHz à 300 GHz) dans des systèmes de communication avec ou sans fil.

On s'intéresse ici plus particulièrement aux oscillateurs à résonateur LC, c'est-à-dire comportant un circuit résonant LC (ou résonateur LC) dont la fréquence de résonance varie en fonction d'une tension appliquée sur un noeud de contrôle du circuit, et un circuit amplificateur comportant au moins un transistor MOS, couplé avec le résonateur LC.

Plus spécifiquement, on s'intéresse ici aux oscillateurs à résonateur LC dits de classe C, c'est-à-dire dans lesquels les grilles du ou des transistors MOS du circuit amplificateur sont polarisées à une tension continue inférieure à la tension de seuil des transistors de façon que les transistors se comportent comme des amplificateurs de classe C.

Résumé

Un mode de réalisation prévoit un oscillateur commandable en tension selon la revendication 1. En particulier, l'oscillateur selon l'invention comporte un résonateur LC commandable en tension comportant au moins un premier noeud de sortie ; un amplificateur comportant au moins un premier transistor MOS double grille comportant des première et deuxième grilles, reliant le premier noeud de sortie à un deuxième noeud d'application d'un potentiel de référence ; et un circuit de régulation adapté à appliquer sur la deuxième grille du premier transistor une tension de polarisation variable en fonction de l'amplitude des oscillations d'un signal fourni sur le premier noeud de sortie de l'oscillateur.

Selon l'invention, l'oscillateur comporte en outre un circuit d'application d'une tension de polarisation fixe sur la première grille du premier transistor.

Selon l'invention, les tensions de polarisation fixe et variable sont telles que l'amplificateur soit polarisé en classe A, B ou AB lors d'une phase de démarrage de l'oscillateur, et soit polarisé en classe C en régime établi.

Selon un mode de réalisation, le premier transistor est un transistor à variation de tension de seuil négative ; et la tension de polarisation variable décroît lorsque l'amplitude des oscillations augmente.

Selon un mode de réalisation, la tension de polarisation fixe est supérieure ou égale à la tension de seuil minimale du premier transistor, et est inférieure à la tension de seuil maximale du premier transistor.

Selon un mode de réalisation, le circuit de régulation comprend un premier circuit adapté à fournir une première tension représentative de l'enveloppe des oscillations, et un deuxième circuit adapté à générer la tension de polarisation variable à partir de la première tension.

Selon un mode de réalisation, le premier circuit comprend un deuxième transistor MOS monté en diode en série avec un premier élément capacitif entre le premier noeud de sortie et le deuxième noeud.

Selon un mode de réalisation, le deuxième circuit comprend des première et deuxième résistances connectées en série entre des première et deuxième électrodes du premier élément capacitif, et une troisième résistance connectée en série avec un troisième transistor MOS entre un troisième noeud d'application d'une tension d'alimentation et le deuxième noeud, la grille du troisième transistor étant reliée au point milieu entre les première et deuxième résistances, et le point milieu entre la troisième résistance et le troisième transistor étant relié à la deuxième grille du premier transistor.

Selon un mode de réalisation, le résonateur comprend une inductance, et une association en série de premier et deuxième éléments capacitifs à capacité variable.

Selon un mode de réalisation, le résonateur LC est un résonateur différentiel comportant en outre un quatrième noeud de sortie ; l'amplificateur comporte au moins un quatrième transistor MOS double grille comportant des première et deuxième grilles, reliant le quatrième noeud de sortie au deuxième noeud ; et le circuit de régulation est adapté à appliquer ladite tension de polarisation variable sur la deuxième grille du deuxième transistor.

Selon selon l'invention, l'amplificateur comporte des deuxième et troisième éléments capacitifs reliant respectivement la première grille du premier transistor au quatrième noeud de sortie et la première grille du quatrième transistor au premier noeud de sortie.

Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :

la figure 1 est un schéma électrique d'un exemple d'un oscillateur à résonateur LC parallèle ;
la figure 2 est un schéma électrique d'un exemple d'un oscillateur de classe C à résonateur LC parallèle ;

la figure 3 est un schéma électrique simplifié illustrant un mode de réalisation d'un oscillateur de classe C à résonateur LC parallèle ;

la figure 4 est un schéma électrique représentant plus en détail un exemple d'implémentation d'un oscillateur de classe C à résonateur LC parallèle du type décrit en relation avec la figure 3 ; et

la figure 5 est un schéma électrique illustrant un autre mode de réalisation d'un oscillateur de classe C à résonateur LC.

Description détaillée

De mêmes éléments ont été désignés par de mêmes références aux différentes figures. Dans la présente description, on utilise le terme "connecté" pour désigner une liaison électrique directe, sans composant électronique intermédiaire, par exemple au moyen d'une ou plusieurs pistes conductrices, et le terme "couplé" ou le terme "relié", pour désigner soit une liaison électrique directe (signifiant alors "connecté") soit une liaison via un ou plusieurs composants intermédiaires (résistance, condensateur, transistor, etc.). Sauf précision contraire, les expressions "approximativement", "sensiblement", et "de l'ordre de" signifient à 10 % près, de préférence à 5 % près.

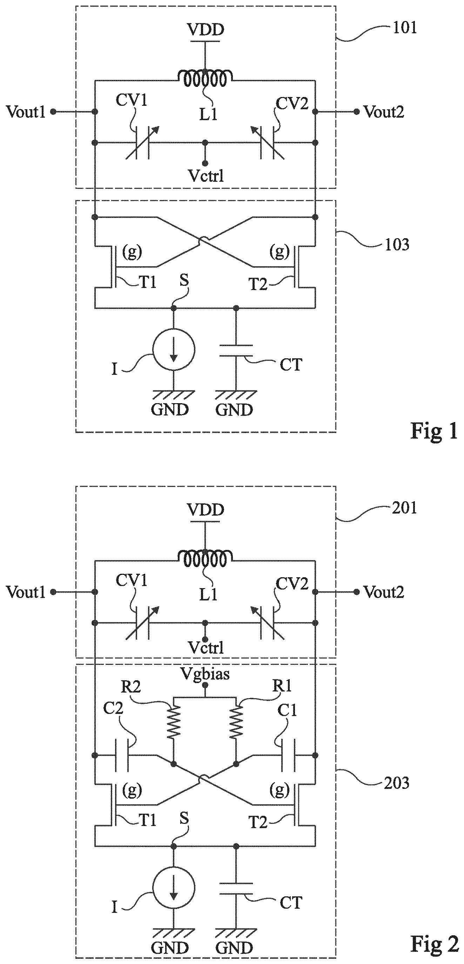

La figure 1 est un schéma électrique d'un exemple d'un oscillateur à résonateur LC parallèle.

L'oscillateur de la figure 1 comprend un résonateur LC parallèle 101 couplé entre deux noeuds de sortie $V_{out1}$ et $V_{out2}$ de l'oscillateur. Le résonateur 101 comprend une inductance L1 dont une première extrémité est reliée (connectée dans l'exemple représenté) au noeud $V_{out1}$ et dont la deuxième extrémité est reliée (connectée dans l'exemple représenté) au noeud $V_{out2}$, le point milieu de l'inductance L1 étant relié à un noeud $V_{DD}$ d'application d'une tension d'alimentation fixe (continue). Le résonateur 101 comprend en outre, en parallèle de l'inductance L1, deux éléments capacitifs à capacité variable CV1 et CV2, par exemple des condensateurs à capacité variable, reliés en série. Plus particulièrement, dans l'exemple représenté, l'élément capacitif CV1 a une première électrode connectée à la première extrémité de l'inductance L1 et une deuxième électrode connectée à une première électrode de l'élément capacitif CV2, et l'élément capacitif CV2 a une deuxième électrode connectée à la deuxième extrémité de l'inductance L1. Les valeurs des capacités des éléments CV1 et CV2 varient en fonction d'une tension de commande appliquée sur un noeud de contrôle $V_{ctrl}$ du résonateur, le point milieu entre les éléments CV1 et CV2 dans l'exemple représenté. Dans cet exemple, la tension d'alimentation continue appliquée sur le noeud $V_{DD}$ et la tension de commande appliquée sur le noeud $V_{ctrl}$ sont référencées par rapport à un noeud GND d'application d'un potentiel de référence de l'oscillateur, par exemple la masse.

L'oscillateur de la figure 1 comprend en outre un circuit amplificateur 103 couplé en parallèle du résonateur LC. Le circuit 103 comprend une paire de transistors MOS T1 et T2, des transistors à canal N dans l'exemple représenté. Les transistors T1 et T2 sont par exemple identiques aux dispersions de fabrication près. Le transistor T1 relie le noeud $V_{out1}$ au noeud GND via ses noeuds de conduction (drain et source), et le transistor T2 relie le noeud $V_{out2}$ au noeud GND via ses noeuds de conduction. Plus particulièrement, dans l'exemple représenté, le drain du transistor T1 est connecté au noeud $V_{out1}$, le drain du transistor T2 est connecté au noeud $V_{out2}$, et les sources des transistors T1 et T2 sont connectées à un même noeud S relié au noeud GND. Dans cet exemple, le noeud S est relié au noeud GND d'une part par une source de courant I, et d'autre part par un élément capacitif CT, par exemple un condensateur, connecté en parallèle de la source de courant I. Les transistors T1 et T2 forment une paire différentielle croisée, c'est-à-dire que la grille (g) du transistor T1 est reliée (connectée dans cet exemple) au drain du transistor T2, et que la grille (g) du transistor T2 est reliée (connectée dans cet exemple) au drain du transistor T1.

Le fonctionnement de l'oscillateur de la figure 1 est le suivant. Le circuit amplificateur 103 se comporte comme une résistance négative couplée en parallèle du résonateur 101, fournissant de l'énergie au résonateur 101 de manière à compenser la résistance interne de ce dernier. En régime établi, le circuit amplificateur 103 assure le maintien des oscillations du résonateur 101, les noeuds de sortie $V_{out1}$ et $V_{out2}$ fournissant deux tensions alternatives sensiblement de même fréquence (égale à la fréquence de résonance du résonateur 101) et de même amplitude, mais en opposition de phase. Si l'on désigne par L l'inductance totale du résonateur 101 et par C la capacité totale du résonateur 101, la fréquence f d'oscillation du circuit 101 s'exprime comme suit :

$$f = 1/2\pi\sqrt{LC}.$$ Cette fréquence de sortie est commandable en tension via le noeud $V_{ctrl}$.

L'architecture de la figure 1 présente l'avantage d'être robuste au démarrage, et simple à mettre en oeuvre.

La figure 2 est un schéma électrique d'un exemple d'un oscillateur de classe C à résonateur LC parallèle.

L'oscillateur de la figure 2 comprend un résonateur LC parallèle 201 couplé entre deux noeuds de sortie $V_{out1}$ et $V_{out2}$ de l'oscillateur. Le résonateur 201 est par exemple identique au résonateur 101 décrit en relation avec la figure 1.

L'oscillateur de la figure 2 comprend en outre un circuit amplificateur 203 couplé en parallèle du résonateur LC. Dans cet exemple, le circuit amplificateur 203 comprend les mêmes éléments que le circuit amplificateur 103 de la figure 1, agencés sensiblement de la même manière, mais diffère du circuit 103 en ce que les grilles (g) des transistors T1 et T2 ne sont pas directement connectées aux drains des transistors T2 et T1. Le circuit 203 comprend en effet un élément capacitif de découplage C1, par exemple un condensateur, reliant la grille du transistor T1 au drain du transistor T2, et un élément capacitif de découplage C2, par exemple identique à l'élément C1 aux dispersions de fabrication près, reliant la grille du transistor T2 au drain du transistor T1. Le circuit 203 comprend en outre un circuit d'application d'une tension de polarisation continue sur les grilles des transistors T1 et T2. Plus particulièrement, dans cet exemple, la grille du transistor T1 est reliée à un noeud $V_{gbias}$ d'application d'une tension de polarisation continue par l'intermédiaire d'une résistance R1, et la grille du transistor T2 est reliée au noeud $V_{gbias}$ par l'intermédiaire d'une résistance R2, par exemple identique à la résistance R1 aux dispersions de fabrication près. Les éléments capacitifs C1 et C2 sont adaptés à empêcher la transmission, sur les noeuds de sortie $V_{out1}$ et $V_{out2}$ de l'oscillateur, de la tension continue de polarisation appliquée sur le noeud $V_{gbias}$, tout en transmettant sur les grilles des transistors T1 et T2 la tension alternative fournie sur les noeuds de sortie $V_{out1}$ et $V_{out2}$ de l'oscillateur.

Le fonctionnement de l'oscillateur de la figure 2 est similaire à celui de l'oscillateur de la figure 1, à ceci près que, dans l'exemple de la figure 2, une tension de polarisation $V_{gbias}$ continue inférieure à la tension de seuil $V_{th}$ des transistors T1 et T2 est appliquée sur les grilles des transistors T1 et T2 (via le noeud $V_{gbias}$), de façon que les transistors T1 et T2 se comportent comme des amplificateurs de classe C, c'est-à-dire qu'ils aient un angle de conduction inférieur à 180° de la phase du signal amplifié (à savoir le signal oscillant de sortie du résonateur LC).

La polarisation en classe C du circuit amplificateur 203 permet de réduire à la fois le bruit de phase et la consommation de l'oscillateur par rapport à des architectures à fonctionnement en classe A du type décrit en relation avec la figure 1.

Le gain procuré en termes de bruit de phase et de consommation est d'autant plus élevé que la tension de polarisation appliquée sur les grilles des transistors T1 et T2 est faible. Toutefois, l'application d'une tension de polarisation trop faible sur les grilles des transistors T1 et T2 peut empêcher le démarrage de l'oscillateur.

Pour tenter de satisfaire ces deux objectifs contradictoires (a) robustesse au démarrage et b) bruit de phase et consommation réduits), diverses architectures d'oscillateur de classe C à résonateur LC parallèle ont été proposées, notamment dans les articles "2.4-GHz band low-voltage class-C PMOS VCO IC with amplitude feedback loop"de Xu Xiao et al (2015 ASIA-PACIFIC MICROWAVE CONFERENCE (APMC), IEEE, vol. 3, 6 décembre 2015, pages 1-3), "A 0.3-V power supply 2.4-GHz-band Class-C VCO IC with amplitude feedback loop in 65-nm CMOS" de Yang Xin et al. (ANALOG INTEGRATED CIRCUITS AND SIGNAL PROCESSING, SPRINGER NEW YORK LLC, US, vol. 81, no. 3, 10 juillet 2014, pages 583-591),
"A 0.114-mW dual-conduction class-C CMOS VCO with 0.2-V power supply" de K. Okada et al. (IEEE Symp.

VLSIC, 2009, pp. 228-229), "An improved dual-conduction class-C VCO using a tail resistor" de Y. Takeuchi et al. (IEEE EuMIC, 2011, pp. 204-207), "High-swing class-C VCO" de M. Tohidian et al. (IEEE ESSCIRC, 2011, pp. 495-498), "A low power, start-up ensured and constant amplitude class-C VCO in 0.18mCMOS" de J. Chen et al. (IEEE Microwave. Wireless Compon. Lett., vol. 21, no. 8, pp. 427-429, Aug. 2011), et "Class-C VCO With Amplitude Feedback Loop for Robust Start-Up and Enhanced Oscillation Swing" de Wei Deng et al. (IEEE Journal of Solid-State Circuits, vol. 48, no. 2, pp. 429-440, Feb. 2013), ainsi que dans les brevets JP2014183371 A, US8149067 et US8710937. Notamment, une variation de la polarisation de la grille arrière est décrite dans les brevets US2007/080754 A1 et US2009/134947 A1.

Les solutions décrites dans ces publications ont pour point commun d'appliquer sur les grilles des transistors MOS du circuit amplificateur une première tension de polarisation pour la phase de démarrage, et une deuxième tension de polarisation inférieure à la première tension pour le fonctionnement en régime établi. Les architectures proposées sont toutefois complexes. En particulier, les solutions prévoyant un ajustement dynamique de la tension de polarisation appliquée sur les grilles des transistors MOS du circuit amplificateur ont pour inconvénient d'être invasives, dans la mesure où les grilles des transistors MOS du circuit amplificateur reçoivent aussi le signal alternatif oscillant à amplifier. Ainsi, un disfonctionnement des circuits de contrôle de la tension de polarisation des transistors MOS peut provoquer un arrêt des oscillations, et rendre le circuit inutilisable. En outre, dans les solutions décrites dans les publications susmentionnées, pour tenir compte notamment des dispersions de fabrication et de température, une marge de sécurité doit être prise lors du choix du point de polarisation des transistors, afin de ne pas risquer un arrêt non souhaité des oscillations. Il en résulte que le point de polarisation optimal en termes de bruit de phase et de consommation ne peut pas être atteint.

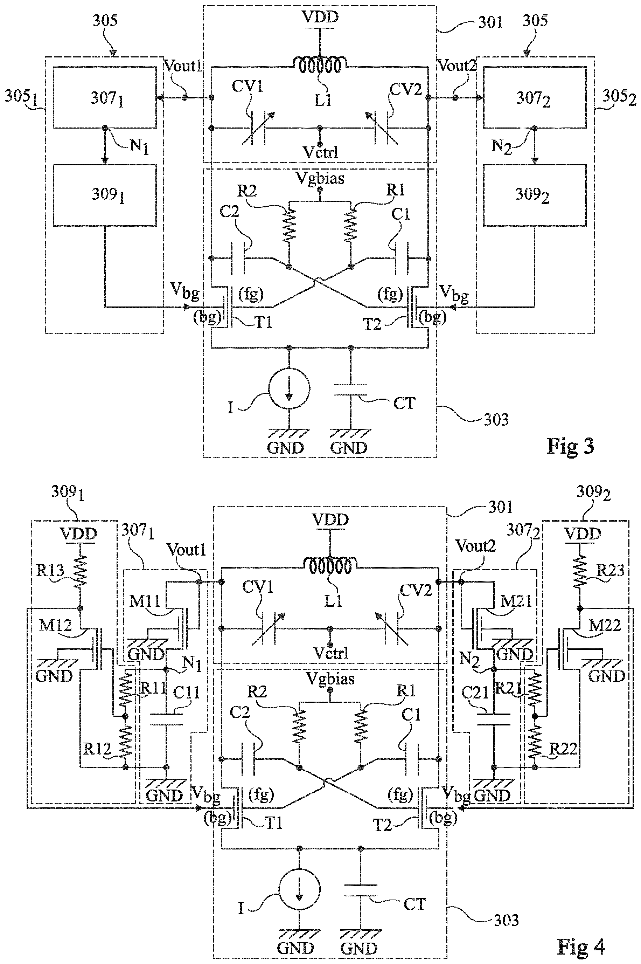

La figure 3 est un schéma électrique simplifié illustrant un exemple d'un mode de réalisation d'un oscillateur de classe C à résonateur LC parallèle.

L'oscillateur de la figure 3 comprend un résonateur LC parallèle 301 couplé entre des noeuds de sortie $V_{out1}$ et $V_{out2}$ de l'oscillateur. Le résonateur 301 est par exemple identique au résonateur 201 de l'oscillateur de la figure 2.

L'oscillateur de la figure 3 comprend en outre un circuit amplificateur 303, couplé en parallèle du résonateur 301. Le circuit amplificateur 303 de la figure 3 est identique ou similaire au circuit amplificateur 203 de la figure 2, à ceci près que, dans le circuit 303 de la figure 3, les transistors MOS T1 et T2 sont des transistors MOS à double-grille.

Par transistor MOS à double-grille, on entend ici un transistor comprenant une région de formation de canal bordée latéralement d'une part par une région de source et d'autre part par une région de drain, et comportant en outre une première grille de commande ou grille de face avant (fg), disposée au-dessus de la région de formation de canal et isolée de la région de formation de canal par une couche diélectrique, et une deuxième grille de commande ou grille de face arrière (bg), disposée sous la région de formation de canal. Dans un tel transistor, le courant circulant entre le drain et la source du transistor est fonction non seulement du potentiel appliqué sur la grille de face avant du transistor, mais aussi du potentiel appliqué sur sa grille de face arrière. En particulier, la tension de seuil du transistor, c'est-à-dire la tension minimale à appliquer entre la grille de face avant et la source du transistor pour rendre le transistor passant, dépend du potentiel appliqué sur la grille de face arrière du transistor.

Les transistors T1 et T2 sont par exemple des transistors de type SOI (de l'anglais "Semiconductor On Insulator" - semiconducteur sur isolant), la grille de face arrière étant alors isolée de la région de formation de canal par une couche diélectrique. De préférence, les transistors T1 et T2 sont des transistors de type FDSOI (de l'anglais "Fully Depleted Semiconductor On Insulator" - semiconducteur entièrement déplété sur isolant), c'est-à-dire des transistors SOI dans lesquels la région de formation de canal est entièrement déplétée en l'absence de polarisation du transistor. En effet, dans un transistor FDSOI, les variations du potentiel de commande appliqué sur la grille de face arrière du transistor provoquent des variations significatives de la tension de seuil du transistor, ce qui est particulièrement adapté à la mise en oeuvre des modes de réalisation qui vont être décrits, comme cela ressortira plus clairement de la suite de la description. Les modes de réalisation décrits ne se limitent toutefois pas au cas où les transistors T1 et T2 sont de type SOI ou FDSOI. Plus généralement, les modes de réalisation décrits s'appliquent à tous types de transistors MOS à deux grilles de commande disposées respectivement du côté de la face avant et du côté de la face arrière de la région de formation de canal du transistor. A titre d'exemple, les modes de réalisation décrits sont compatibles avec des transistors MOS de type "bulk", comportant une région de corps semiconductrice disposée sous la région de formation de canal, dont la face supérieure est en contact avec la face inférieure de la région de formation de canal. Dans ce cas, la grille de face arrière est constituée par la région de corps du transistor, et n'est pas isolée de la région de formation de canal. A titre de variante, les transistors T1 et T2 peuvent être des transistors de type FinFET (ou transistors à ailettes).

Le montage des transistors T1 et T2 de la figure 3 est similaire à ce qui a été décrit en relation avec la figure 2, en remplaçant les grilles (g) des transistors T1 et T2 du circuit de la figure 2 par les grilles de face avant (fg) des transistors T1 et T2 dans le circuit de la figure 3.

L'oscillateur de la figure 3 comprend en outre un circuit de régulation 305 relié d'une part aux noeuds de sortie $V_{out1}$ et $V_{out2}$ de l'oscillateur, et d'autre part aux grilles de face arrière (bg) des transistors T1 et T2. Le circuit 305 est adapté à appliquer sur les grilles de face arrière (bg) des transistors T1 et T2 une tension de polarisation continue $V_{bg}$ fonction de l'amplitude des oscillations du signal de sortie de l'oscillateur. Plus particulièrement, dans cet exemple, les transistors double grille T1 et T2 sont des transistors à variation de tension de seuil négative, c'est-à-dire que plus la tension de polarisation appliquée sur leur grille de face arrière est élevée, plus leur tension de seuil est faible. Dans ce cas, le circuit 305 est configuré pour appliquer sur les grilles de face arrière des transistors T1 et T2 une tension de polarisation $V_{bg}$ décroissant lorsque l'amplitude des oscillations augmente. A titre d'exemple, le circuit 305 est configuré pour appliquer sur les grilles de face arrière des transistors T1 et T2 une tension $V_{bg}$ décroissant de manière continue en fonction de l'amplitude des oscillations, entre une valeur maximale $V_{bgmax}$ lorsque l'amplitude des oscillations est nulle, et une valeur minimale $V_{bgmin}$ lorsque l'amplitude des oscillations atteint sa valeur maximale. La valeur $V_{bgmax}$ est inférieure ou égale à la tension nominale maximale de polarisation de face arrière que peuvent supporter les transistors T1 et T2, et la valeur $V_{bgmin}$ est inférieure à la valeur $V_{bgmax}$ et supérieure ou égale à 0 V.

En fonctionnement, une tension de polarisation continue fixe est appliquée sur les grilles de face avant des transistors T1 et T2, via le noeud $V_{gbias}$. Cette tension $V_{gbias}$ est de préférence choisie supérieure ou égale à la tension de seuil minimale $V_{thmin}$ des transistors T1 et T2, c'est-à-dire la tension de seuil des transistors T1 et T2 lorsque leurs grilles de face arrière sont polarisées à la tension $V_{bgmax}$. De cette manière, les transistors T1 et T2 sont polarisés en classe B, AB ou A au démarrage de l'oscillateur, c'est-à-dire lorsque l'amplitude des oscillations du signal de sortie est nulle. Ceci garantit un démarrage robuste de l'oscillateur.

Lorsque l'oscillateur démarre, un signal oscillant apparaît sur ses noeuds de sortie $V_{out1}$, $V_{out2}$. Le circuit 305 modifie alors de manière continue la tension de polarisation $V_{bg}$ appliquée sur les grilles de face arrière des transistors T1 et T2 en fonction de l'amplitude des oscillations du signal fourni sur les noeuds $V_{out1}$, $V_{out2}$. En régime établi, la tension $V_{bg}$ atteint sa valeur minimale $V_{bgmin}$, et la tension de seuil des transistors T1 et T2 atteint en conséquence sa valeur maximale $V_{thmax}$. La tension de polarisation fixe $V_{gbias}$ appliquée sur les grilles de face (fg) avant des transistors T1 et T2 est choisie inférieure à la tension de seuil maximale $V_{thmax}$ des transistors T1 et T2, de façon à obtenir une polarisation en classe C des transistors T1 et T2 en régime établi.

Dans l'exemple représenté, le circuit 305 comprend un premier sous-circuit $305_1$ connecté d'une part au noeud $V_{out1}$ et d'autre part à la grille de face arrière (bg) du transistor T1, et un deuxième sous-circuit $305_2$ connecté d'une part au noeud $V_{out2}$ et d'autre part à la grille de face arrière (bg) du transistor T2. Dans cet exem-

ple, le sous-circuit $305_1$ comprend un circuit de redressement et de filtrage $307_1$, ou circuit détecteur d'enveloppe, connecté au noeud $V_{out1}$ et adapté à fournir, sur un noeud de sortie $N_1$, une tension représentative de l'enveloppe du signal oscillant présent sur le noeud $V_{out1}$. Le sous-circuit $305_1$ comprend en outre un circuit de mise en forme $309_1$ connecté au noeud $N_1$ et adapté à appliquer, sur la grille de face arrière (bg) du transistor T1, une tension de polarisation fonction de l'amplitude du signal d'enveloppe fourni par le détecteur d'enveloppe $307_1$ sur le noeud $N_1$. De façon similaire, le sous-circuit $305_2$ comprend un circuit de redressement et de filtrage $307_2$, ou circuit détecteur d'enveloppe, connecté au noeud $V_{out2}$ et adapté à fournir, sur un noeud de sortie $N_2$, une tension représentative de l'enveloppe du signal oscillant présent sur le noeud $V_{out2}$. Le sous-circuit $305_2$ comprend en outre un circuit de mise en forme $309_2$ connecté au noeud $N_2$ et adapté à appliquer, sur la grille de face arrière (bg) du transistor T2, une tension de polarisation fonction de l'amplitude du signal d'enveloppe fourni par le détecteur d'enveloppe $307_2$ sur le noeud $N_2$. Les sous-circuits $305_1$ et $305_2$ sont par exemple identiques aux dispersions de fabrication près. En pratique, la tension de polarisation appliquée sur la grille de face arrière (bg) du transistor T1 est sensiblement identique à la tension de polarisation appliquée sur la grille de face arrière (bg) du transistor T2. A titre de variante, seul l'un des deux sous-circuits $305_1$ et $305_2$ peut être prévu, la sortie de ce sous-circuit étant connectée à la fois à la grille de face arrière (bg) du transistor T1 et à la grille de face arrière (bg) du transistor T2. L'agencement représenté en figure 3 comportant deux sous-circuits $305_1$ et $305_2$ identiques séparés pour la polarisation des transistors T1 et T2 est toutefois préférable dans la mesure où il permet de symétriser la charge vue par les noeuds de sortie $V_{out1}$ et $V_{out2}$ du résonateur.

La figure 4 est un schéma électrique représentant plus en détail un exemple d'implémentation de l'oscillateur de la figure 3. Plus particulièrement, la figure 4 représente de façon plus détaillée un exemple de réalisation du circuit de régulation 305 de l'oscillateur de la figure 3.

Dans cet exemple, le circuit de détection d'enveloppe $307_1$ du sous-circuit $305_1$ comprend un transistor MOS M11 monté en diode, reliant le noeud $V_{out1}$ au noeud N1. Dans cet exemple, le transistor M11 est un transistor à canal N, dont les noeuds de conduction sont connectés respectivement au noeud $V_{out1}$ et au noeud N1, et dont la grille est connectée au noeud $V_{out1}$. Le transistor M11 peut être un transistor simple grille ou un transistor double grille. Dans l'exemple représenté, le transistor M11 est un transistor double grille dont la grille de face arrière est connectée à la masse (noeud GND) et dont la grille de face avant est connectée au noeud $V_{out1}$. Le circuit de détection d'enveloppe $307_1$ comprend en outre un élément capacitif C11, par exemple un condensateur, connecté entre le noeud $N_1$ et le noeud GND.

Le circuit de mise en forme $309_1$ comprend deux résistances R11 et R12 connectées en série entre le noeud $N_1$ et le noeud GND, en parallèle de l'élément capacitif C11 du circuit $307_1$. Les résistances R11 et R12 forment un premier pont diviseur de tension abaissant le niveau de la tension d'enveloppe délivrée par le circuit $307_1$ sur le noeud $N_1$. Le circuit $309_1$ comprend en outre une résistance R13 en série avec un transistor MOS M12 entre les noeuds VDD et GND. Plus particulièrement, dans l'exemple représenté, le transistor M12 est un transistor à canal N dont le drain est relié au noeud VDD par l'intermédiaire de la résistance R13 et dont la source est connectée au noeud GND. La grille du transistor M12 est reliée au noeud de sortie du pont diviseur de tension formé par les résistances R11 et R12, c'est-à-dire au point milieu entre les résistances R11 et R12. Le transistor M12 peut être un transistor simple grille ou un transistor double grille. Dans l'exemple représenté, le transistor M12 est un transistor double grille dont la grille de face arrière est connectée à la masse (noeud GND) et dont la grille de face avant est connectée au point milieu entre les résistances R11 et R12. La résistance R13 et le transistor M12 forment ensemble un deuxième pont diviseur de tension résistif fournissant une tension dont le niveau est d'autant plus faible que la résistance du transistor M12 est faible, c'est-à-dire que le niveau de tension sur le noeud $N_1$ est élevé. Le noeud de sortie du pont diviseur de tension formé par la résistance R13 et le transistor M12, c'est-à-dire le point milieu entre la résistance R13 et le transistor M12, est connecté à la grille de face arrière (bg) du transistor T1.

De façon similaire, le circuit de détection d'enveloppe $307_2$ du sous-circuit $305_2$ comprend un transistor MOS M21 monté en diode, reliant le noeud $V_{out1}$ au noeud $N_2$, et un élément capacitif C21 connecté entre le noeud $N_2$ et le noeud GND. De plus, le circuit de mise en forme $309_2$ comprend deux résistances R21 et R22 connectées en série entre le noeud $N_2$ et le noeud GND, en parallèle de l'élément capacitif C21. Le circuit $309_2$ comprend en outre une résistance R23 en série avec un transistor MOS M22 entre les noeuds VDD et GND, la grille du transistor M22 étant reliée au point milieu entre les résistances R21 et R22, et le point milieu entre la résistance R23 et le transistor M22 étant relié à la grille de face arrière (bg) du transistor T2.

Un avantage des modes de réalisation décrits en relation avec les figures 3 et 4 réside dans l'autorégulation du point de polarisation des transistors T1 et T2. En effet, le circuit 305 vient automatiquement placer le point de polarisation des transistors T1 et T2 à un niveau optimal en termes de consommation, tout en prévenant tout risque d'interruption des oscillations. En particulier, lorsque la tension de polarisation $V_{bg}$ appliquée par le circuit 305 sur la grille de face arrière des transistors T1 et T2 devient trop faible, l'amplitude des oscillations du signal de sortie du résonateur 301 commence à diminuer, ce qui conduit à ré-augmenter la tension $V_{bg}$ et ainsi à rétablir l'amplitude des oscillations. Ainsi, en régime établi, la tension de polarisation $V_{bg}$ se stabilise automatiquement à un niveau optimal en termes de consommation et de bruit de phase. Ceci constitue notamment une différence par rapport aux publications susmentionnées dans lesquelles une marge de sécurité doit être prévue lors du choix du point de polarisation en classe C des transistors, pour tenir compte d'éventuelles dispersions de fabrication et/ou de température.

Un autre avantage des modes de réalisation décrits est que l'ajustement dynamique du point de polarisation des transistors T1 et T2 pour, dans une première phase, satisfaire aux conditions de démarrage de l'oscillateur, et, dans une deuxième phase, obtenir un fonctionnement en classe C procurant de bonnes performances en termes de bruit de phase et de consommation, se fait par l'intermédiaire des grilles de face arrière des transistors T1 et T2. Ainsi, le circuit de régulation 305 est non invasif, puisque la tension de polarisation modifiée dynamiquement par le circuit 305 n'est pas superposée au signal oscillant haute fréquence à amplifier. La tension de polarisation $V_{gbias}$ appliquée sur la grille de face avant des transistors T1 et T2 reste quant à elle constante pendant le fonctionnement de l'oscillateur.

Des modes de réalisation particuliers ont été décrits. Diverses variantes et modifications apparaîtront à l'homme de l'art. En particulier, les modes de réalisation décrits ne se limitent pas à l'exemple des résonateurs LC parallèles 301 représenté sur les figures 3 et 4. Plus généralement, les modes de réalisation décrits sont compatibles avec toute autre architecture de résonateur LC parallèle à fréquence de résonance commandable en tension.

En outre, les modes de réalisation décrits ne se limitent pas à l'exemple particulier d'agencement du circuit amplificateur 303 représenté sur les figures 3 et 4. Plus généralement, les modes de réalisation sont compatibles avec d'autres architectures de circuit amplificateur comportant une paire différentielle croisée de transistors MOS double grille.

En outre, les modes de réalisation décrits ne se limitent pas aux exemples particuliers d'implémentation du circuit de régulation 305 décrits en relation avec les figures 3 et 4. Plus généralement, d'autres circuits de régulation adaptés à mettre en oeuvre le fonctionnement recherché peuvent être prévus.

De plus, les modes de réalisation décrits peuvent être adaptés au cas où les transistors T1 et T2 sont des transistors à variation de tension de seuil positive.

Par ailleurs, on a décrit ci-dessus des exemples de réalisation d'oscillateurs à résonateur LC différentiel. Les modes de réalisation décrits ci-dessus peuvent toutefois être adaptés à des oscillateurs à résonateur LC non différentiel, c'est-à-dire dans lesquels le signal oscillant de sortie de l'oscillateur est référencé à la masse.

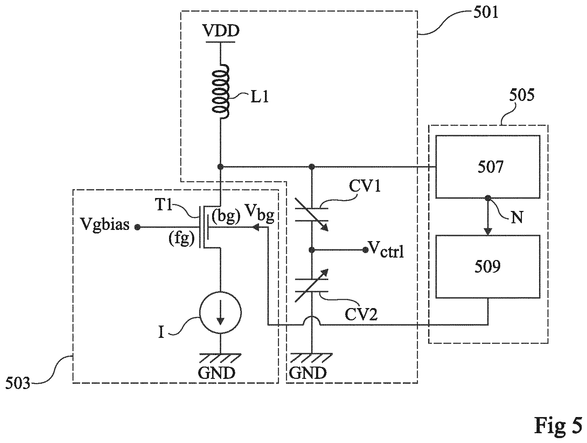

La figure 5 est un schéma électrique illustrant un exemple d'un mode de réalisation d'un oscillateur de classe C à résonateur LC non différentiel.

L'oscillateur de la figure 5 comprend un résonateur LC 501 comportant une inductance L1 dont une première extrémité est reliée à un noeud $V_{DD}$ d'application d'une tension d'alimentation fixe (continue) et dont la deuxième extrémité est reliée à un noeud de sortie $V_{out1}$ de l'oscillateur. Le résonateur 501 comprend en outre deux éléments capacitifs à capacité variable CV1 et CV2, par exemple des condensateurs à capacité variable, reliés en série. Plus particulièrement, dans l'exemple représenté, l'élément capacitif CV1 a une première électrode reliée au noeud $V_{out1}$ et une deuxième électrode connectée à une première électrode de l'élément capacitif CV2, et l'élément capacitif CV2 a une deuxième électrode reliée à un noeud GND d'application d'un potentiel de référence de l'oscillateur, par exemple la masse. Les valeurs des capacités des éléments CV1 et CV2 varient en fonction d'une tension de commande appliquée sur un noeud de contrôle $V_{ctrl}$ du résonateur, le point milieu entre les éléments CV1 et CV2 dans l'exemple représenté.

L'oscillateur de la figure 5 comprend en outre un circuit amplificateur 503 couplé au résonateur LC. Le circuit 503 comprend un transistor MOS T1, un transistor à canal N dans l'exemple représenté. Le transistor T1 relie le noeud $V_{out1}$ au noeud GND via ses noeuds de conduction. Plus particulièrement, dans l'exemple représenté, le drain du transistor T1 est connecté au noeud $V_{out1}$, et la source du transistor T1 est reliée au noeud GND par une source de courant I. De même que dans les exemples des figures 3 et 4, le transistor T1 est un transistor double-grille. La grille de face avant (fg) du transistor T1 est reliée à un noeud $V_{gbias}$ d'application d'une tension de polarisation continue.

L'oscillateur de la figure 5 comprend en outre un circuit de régulation 505 relié d'une part au noeud de sortie $V_{out1}$ de l'oscillateur, et d'autre part à la grille de face arrière (bg) du transistor T1. Comme le circuit 305 des figures 3 et 4, le circuit 505 est adapté à appliquer sur la grille de face arrière (bg) du transistor T1 une tension de polarisation continue $V_{bg}$ fonction de l'amplitude des oscillations du signal de sortie de l'oscillateur. Dans l'exemple représenté, le circuit 505 comprend un circuit de redressement et de filtrage 507, connecté au noeud $V_{out1}$ et adapté à fournir, sur un noeud de sortie N, une tension représentative de l'enveloppe du signal oscillant présent sur le noeud $V_{out1}$. Le circuit 507 est par exemple identique ou similaire au circuit $307_1$ décrit en relation avec les figures 3 et 4. Le circuit 505 comprend en outre un circuit de mise en forme 509 connecté au noeud N et adapté à appliquer, sur la grille de face arrière (bg) du transistor T1, une tension de polarisation fonction de l'amplitude du signal d'enveloppe fourni par le détecteur d'enveloppe 507 sur le noeud N. Le circuit 509 est par exemple identique ou similaire au circuit $309_1$ décrit en relation avec les figures 3 et 4.

Le fonctionnement de l'oscillateur de la figure 5 est similaire au fonctionnement décrit ci-dessus des oscillateurs différentiels. Le circuit amplificateur 503 se comporte comme une résistance négative couplée au résonateur 501, fournissant de l'énergie au résonateur 501 de manière à compenser la résistance interne de ce dernier. En régime établi, le circuit amplificateur 503 assure le maintien des oscillations du résonateur 501, le noeud de sortie $V_{out1}$ fournissant une tension alternative référencée à la masse, de fréquence égale à la fréquence de résonance du résonateur 501. Une tension de polarisation $V_{gbias}$ continue est appliquée sur la grille du transistor T1 (via le noeud $V_{gbias}$). Cette tension $V_{gbias}$ est de préférence choisie supérieure ou égale à la tension de seuil minimale $V_{thmin}$ du transistor T1, de façon que le transistor T1 soit polarisé en classe B, AB ou A au démarrage de l'oscillateur. Lorsque l'oscillateur démarre, un signal oscillant apparaît sur son noeud de sortie $V_{out1}$. Le circuit 505 modifie alors de manière continue la tension de polarisation $V_{bg}$ appliquée sur la grille de face arrière du transistor T1 en fonction de l'amplitude des oscillations. En régime établi, la tension $V_{bg}$ atteint sa valeur minimale $V_{bgmin}$, et la tension de seuil du transistor T1 atteint en conséquence sa valeur maximale $V_{thmax}$. La tension de polarisation fixe $V_{gbias}$ appliquée sur la grille de face avant du transistor T1 est choisie inférieure à la tension de seuil maximale $V_{thmax}$ du transistor T1, de façon à obtenir une polarisation en classe C du transistor T1 en régime établi.

## Revendications

1. Oscillateur commandable en tension, comportant :

un résonateur LC (301 ; 501) commandable en tension comportant des premier ($V_{out1}$) et deuxième ($V_{out2}$) noeuds de sortie ;
un amplificateur (303 ; 503) comportant :

- un premier transistor MOS FDSOI (T1) comportant une grille de face avant (fg) et une grille de face arrière (bg), reliant le premier noeud de sortie ($V_{out1}$) du résonateur à un noeud (GND) d'application d'un potentiel de référence,
- un deuxième transistor MOS FDSOI (T2) comportant une grille de face avant (fg) et une grille de face arrière (bg), reliant le deuxième noeud de sortie ($V_{out2}$) du résonateur audit noeud (GND) d'application d'un potentiel de référence, et
- des premier (C1) et deuxième (C2) éléments capacitifs de découplage reliant respectivement la grille de face avant (fg) du premier transistor (T1) au deuxième noeud de sortie ($V_{out2}$) du résonateur et la grille de face avant (fg) du deuxième transistor (T2) au premier noeud de sortie ($V_{out1}$) du résonateur ;

un circuit de régulation (305 ; 505) adapté à appliquer sur les grilles de face arrière (bg) des premier (T1) et deuxième (T2) transistors une tension de polarisation ($V_{bg}$) variable en fonction de l'amplitude des oscillations d'un signal fourni sur le premier ($V_{out1}$) ou deuxième ($V_{out2}$) noeud de sortie du résonateur ; et
un circuit (R1, R2) d'application d'une tension de polarisation fixe ($V_{gbias}$) sur les grilles de face avant (fg) des premier (T1) et deuxième (T2) transistors,
dans lequel les tensions de polarisation fixe ($V_{gbias}$) et variable ($V_{bg}$) sont telles que la tension de polarisation fixe (Vgbias) soit supérieure ou égale à la tension de seuil des premier (T1) et deuxième (T2) transistors lors d'une phase de démarrage de l'oscillateur, et soit inférieure à la tension de seuil des premier (T1) et deuxième (T2) transistors en régime établi, de façon que l'amplificateur (303 ; 503) soit polarisé en classe A, B ou AB lors de la phase de démarrage de l'oscillateur, et soit polarisé en classe C en régime établi, la variation de la tension de seuil des premier (T1) et deuxième (T2) transistors entre la phase de démarrage et la phase de régime établi résultant de la variation de la tension de polarisation variable ($V_{bg}$) entre lesdites phases.

2. Oscillateur selon la revendication 1, dans lequel :

les premier (T1) et deuxième (T2) transistors sont des transistors à variation de tension de seuil négative, c'est-à-dire que plus la tension de polarisation variable ($V_{bg}$) appliquée sur leurs grilles de face arrière (bg) est élevée, plus leur tension de seuil est faible ; et
la tension de polarisation variable ($V_{bg}$) décroit depuis une valeur maximale ($V_{bgmax}$) jusqu'à une valeur minimale ($V_{bgmin}$) entre la phase de démarrage et la phase de régime établi.

3. Oscillateur selon la revendication 2, dans lequel la tension de polarisation fixe ($V_{gbias}$) est :

supérieure ou égale à la tension de seuil minimale ($V_{thmin}$) des premier (T1) et deuxième (T2) transistors, c'est-à-dire la tension de seuil des premier et deuxième transistors lorsque la tension de polarisation variable ($V_{bg}$) est à sa valeur maximale ($V_{bgmax}$) ; et
inférieure à la tension de seuil maximale ($V_{thmax}$) des premier (T1) et deuxième (T2) transistors, c'est-à-dire la tension de seuil des premier et deuxième transistors lorsque la tension de polarisation variable ($V_{bg}$) est à sa valeur minimale ($V_{bgmin}$).

4. Oscillateur selon l'une quelconque des revendications 1 à 3, dans lequel le circuit de régulation (305 ;

505) comprend un premier circuit (307₁) adapté à fournir une première tension représentative de l'enveloppe des oscillations, et un deuxième circuit (309₁) adapté à générer la tension de polarisation variable ($V_{bg}$) à partir de la première tension.

5. Oscillateur selon la revendication 4, dans lequel le premier circuit (307₁) comprend un troisième transistor MOS (M11) monté en diode en série avec un troisième élément capacitif (C11) entre le premier noeud de sortie ($V_{out1}$) et le noeud (GND) d'application d'un potentiel de référence.

6. Oscillateur selon la revendication 5, dans lequel le deuxième circuit (309₁) comprend des première (R11) et deuxième (R12) résistances connectées en série entre des première et deuxième électrodes du troisième élément capacitif (C11), et une troisième résistance (R13) connectée en série avec un quatrième transistor MOS (M12) entre un noeud ($V_{DD}$) d'application d'une tension d'alimentation et le noeud (GND) d'application d'un potentiel de référence, la grille du quatrième transistor (M12) étant reliée au point milieu entre les première (R11) et deuxième (R12) résistances, et le point milieu entre la troisième résistance (R13) et le quatrième transistor (M12) étant relié à la grille de face arrière (bg) du premier transistor (T1).

7. Oscillateur selon l'une quelconque des revendications 1 à 6, dans lequel le résonateur (301 ; 501) comprend une inductance (L1), et une association en série de premier (CV1) et deuxième (CV2) éléments capacitifs à capacité variable.

**Patentansprüche**

1. Spannungsgesteuerter Oszillator, der Folgendes aufweist:

einen spannungsgesteuerten LC-Resonator (301; 501), der erste ($V_{out1}$) und zweite ($V_{out2}$) Ausgangsknoten aufweist;
einen Verstärker (303; 503), der Folgendes aufweist:

einen ersten FDSOI-MOS-Transistor (T1), der ein Front-Gate (fg) und ein Back-Gate (bg) aufweist, die den ersten Ausgangsknoten ($V_{out1}$) des Resonators mit einem Knoten (GND) des Anlegens eines Referenzpotentials koppeln,
einen zweiten FDSOI-MOS-Transistor (T2), der ein Front-Gate (fg) und ein Back-Gate (bg) aufweist, die den zweiten Ausgangsknoten ($V_{out2}$) des Resonators mit dem Knoten (GND) des Anlegens eines Referenzpotentials koppeln, und
erste (C1) und zweite (C2) entkoppelnde kapazitive Elemente, die das Front-Gate (fg) des ersten Transistors (T1) an den zweiten Ausgangsknoten ($V_{out2}$) des Resonators bzw. das Front-Gate (fg) des zweiten Transistors (T2) an den ersten Ausgangsknoten ($V_{out1}$) des Resonators koppeln;

eine Regelschaltung (305; 505), die geeignet ist zum Anlegen an das Back-Gate (bg) des ersten (T1) und zweiten (T2) Transistors einer Vorspannung ($V_{bg}$), die gemäß der Amplitude der Schwingungen eines Signals, das an den ersten ($V_{out1}$) und zweiten ($V_{out2}$) Ausgangsknoten des Resonators geliefert wird, variiert; und
eine Schaltung (R1, R2) zum Anlegen einer festen Vorspannung ($V_{gbias}$) an das Front-Gate (fg) des ersten (T1) und zweiten (T2) Transistors, wobei die festen ($V_{gbias}$) und variablen ($V_{bg}$) Vorspannungen derart sind, dass die feste Vorspannung ($V_{gbias}$) höher oder gleich der Schwellenwertspannung der ersten (T1) und zweiten (T2) Transistoren während einer Oszillatorstartphase ist, und geringer als der Spannungsschwellenwert der ersten (T1) und zweiten (T2) Transistoren im stationären Zustand ist, so dass der Verstärker (303; 503) eine Klasse-A-, -B- oder -AB-Vorspannung während der Oszillatorstartphase hat und eine Klasse-C-Vorspannung in dem stationären Zustand hat, wobei die Variation der Schwellenwertspannung der ersten (T1) und zweiten (T2) Transistoren zwischen der Startphase und der stationären Phase aus der Variation der variablen Vorspannung ($V_{bg}$) zwischen den Phasen resultiert.

2. Oszillator nach Anspruch 1, wobei:

die ersten (T1) und zweiten (T2) Transistoren Transistoren mit negativer Schwellenspannungsvariation sind, das heißt, dass je höher die variable Vorspannung ($V_{bg}$) ist, die an ihre Back-Gate (bg) angelegt wird, desto geringer ist ihre Schwellenwertspannung; und
die variable Vorspannung ($V_{bg}$) nimmt von einem Maximalwert ($V_{bgmax}$) zu einem Minimalwert ($V_{bgmin}$) zwischen der Startphase und der stationären Phase ab.

3. Oszillator nach Anspruch 2, wobei die feste Vorspannung ($V_{gbias}$) Folgendes ist:

größer oder gleich der minimalen Schwellenspannung ($V_{thmin}$) der ersten (T1) und zweiten (T2) Transistoren, das heißt der Spannungsschwellenwert der ersten und zweiten Transistoren wenn die variable Vorspannung ($V_{bg}$) an ihrem Maximalwert ($V_{bgmax}$) ist; und geringer als die maximale Schwellenspannung ($V_{thmax}$) der ersten (T1) und zweiten (T2) Transistoren, das heißt der Spannungsschwellenwert der ersten und zweiten Transistoren wenn die variable Vorspannung ($V_{bg}$) an ihrem Minimalwert ($V_{bgmin}$) ist.

4. Oszillator nach einem der Ansprüche 1 bis 3, wobei die Regelschaltung (305; 505) eine erste Schaltung ($307_1$) aufweist, die geeignet ist zum Liefern einer ersten Spannung, die für die Schwingungshüllen repräsentativ ist, und eine zweite Schaltung ($309_1$), die geeignet ist zum Erzeugen der variablen Vorspannung ($V_{bg}$) von der ersten Spannung.

5. Oszillator nach Anspruch 4, wobei die erste Schaltung ($307_1$) einen dritten Dioden-angeordneten-MOS-Transistor (M11) aufweist, der mit einem dritten kapazitiven Element (C11) zwischen dem ersten Ausgangsknoten ($V_{out1}$) und dem Knoten (GND) des Anlegens eines Referenzpotentials in Reihe geschaltet ist.

6. Oszillator nach Anspruch 5, wobei die zweite Schaltung ($309_1$) erste (R11) und zweite (R12) Widerstände aufweist, die zwischen ersten und zweiten Elektroden des dritten kapazitiven Elements (C11) in Reihe geschaltet sind, und einen dritten Widerstand (R13), der mit einem vierten MOS-Transistor (M12) zwischen Knoten ($V_{DD}$) des Anlegens einer Energielieferspannung und dem Knoten (GND) des Anlegens eines Referenzpotentials in Reihe geschaltet ist, wobei das Gate des vierten Transistors (M12) mit dem Knotenpunkt der ersten (R11) und zweiten (R12) Widerstände gekoppelt ist, und der Knotenpunkt des dritten Widerstands (R13) und des vierten Transistors (M12) an das Back-Gate (bg) des ersten Transistors (T1) gekoppelt ist.

7. Oszillator nach einem der Ansprüche 1 bis 6, wobei der Resonator (301; 501) eine Induktivität (L1) und eine Reihenkombination von ersten (CV1) und zweiten (CV2) kapazitiven Elementen mit variabler Kapazität aufweist.

## Claims

1. A voltage-controlled oscillator, comprising:

   a voltage-controlled LC resonator (301; 501) comprising first ($V_{out1}$) and second ($V_{out2}$) output nodes;
   an amplifier (303; 503) comprising:

   - a first FDSOI MOS transistor (T1) comprising a front gate (fg) and a back gate (bg), coupling the first output node ($V_{out1}$) of the resonator to a node (GND) of application of a reference potential,
   - a second FDSOI MOS transistor (T2) comprising a front gate (fg) and a back gate (bg), coupling the second output node ($V_{out2}$) of the resonator to said node (GND) of application of a reference potential, and
   - first (C1) and second (C2) decoupling capacitive elements coupling respectively the front gate (fg) of the first transistor (T1) to the second output node ($V_{out2}$) of the resonator and the front gate (fg) of the second transistor (T2) to the first output node ($V_{out1}$) of the resonator ;

   a regulation circuit (305; 505) capable of applying to the back gates (bg) of the first (T1) and second (T2) transistors a bias voltage ($V_{bg}$) variable according to the amplitude of the oscillations of a signal delivered on the first ($V_{out1}$) or second ($V_{out2}$) output node of the resonator; and
   a circuit (R1, R2) of application of a fixed bias voltage ($V_{gbias}$) to the front gates (fg) of the first (T1) and second (T2) transistors,
   wherein the fixed ($V_{gbias}$) and variable ($V_{bg}$) bias voltages are such that the fixed bias voltage ($V_{gbias}$) is higher or equal than the threshold voltage of the first (T1) and second (T2) transistors during a start-up phase of the oscillator, and is lower than the voltage threshold of the first (T1) and second (T2) transistors in steady state, so that the amplifier (303; 503) has a class-A, -B, or -AB biasing during the start-up phase of the oscillator, and has a class-C biasing in steady state, the variation of the threshold voltage of the first (T1) and second (T2) transistors between the start-up phase and the steady state resulting from the variation of the variable bias voltage ($V_{bg}$) between said phases.

2. The oscillator of claim 1, wherein:

   the first (T1) and second (T2) transistors are transistors having a negative threshold voltage variation, meaning that the higher the variable bias voltage ($V_{bg}$) applied on their back gates (bg) is, the lower their threshold voltage is ; and the variable bias voltage ($V_{bg}$) decreases from a maximum value ($V_{bgmax}$) to a minimum value ($V_{bgmin}$) between the start-up phase and the steady state.

3. The oscillator of claim 2, wherein the fixed bias voltage ($V_{gbias}$) is:

   greater than or equal to the minimum threshold

voltage ($V_{thmin}$) of the first (T1) and second (T2) transistors, that is the voltage threshold of the first and second transistors when the variable bias voltage ($V_{bg}$) is at its maximal value ($V_{bgmax}$); and

lower than the maximum threshold voltage ($V_{thmax}$) of the first (T1) and second (T2) transistors, that is the threshold voltage of the first and second transistors when the variable bias voltage ($V_{bg}$) is at its minimum value ($V_{bgmin}$).

4. The oscillator of any of claims 1 to 3, wherein the regulation circuit (305; 505) comprises a first circuit ($307_1$) capable of supplying a first voltage representative of the envelope of the oscillations, and a second circuit ($309_1$) capable of generating the variable bias voltage ($V_{bg}$) from the first voltage.

5. The oscillator of claim 4, wherein the first circuit ($307_1$) comprises a third diode-assembled MOS transistor (M11) in series with a third capacitive element (C11) between the first output node ($V_{out1}$) and the node (GND) of application of a reference potential.

6. The oscillator of claim 5, wherein the second circuit ($309_1$) comprises first (R11) and second (R12) resistors series-connected between first and second electrodes of the third capacitive element (C11), and a third resistor (R13) series-connected with a fourth MOS transistor (M12) between a node ($V_{DD}$) of application of a power supply voltage and the node (GND) of application of a reference potential, the gate of the fourth transistor (M12) being coupled to the junction point of the first (R11) and second (R12) resistors, and the junction point of the third resistor (R13) and of the fourth transistor (M12) being coupled to the back gate (bg) of the first transistor (T1).

7. The oscillator of any of claims 1 to 6, wherein the resonator (301; 501) comprises an inductance (L1), and a series association of first (CV1) and second (CV2) variable-capacitance capacitive elements.

Fig 1

Fig 2

Fig 3

Fig 4

Fig 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 2014183371 A
- US 8149067 B
- US 8710937 B
- US 2007080754 A1
- US 2009134947 A1

**Littérature non-brevet citée dans la description**

- 2.4-GHz band low-voltage class-C PMOS VCO IC with amplitude feedback loop. **XU XIAO et al.** ASIA-PACIFIC MICROWAVE CONFERENCE (AP-MC). IEEE, 06 Décembre 2015, vol. 3, 1-3
- A 0.3-V power supply 2.4-GHz-band Class-C VCO IC with amplitude feedback loop in 65-nm CMOS. **YANG XIN et al.** ANALOG INTEGRATED CIRCUITS AND SIGNAL PROCESSING. SPRINGER NEW YORK LLC, 10 Juillet 2014, vol. 81, 583-591
- **K. OKADA et al.** A 0.114-mW dual-conduction class-C CMOS VCO with 0.2-V power supply. *IEEE Symp. VLSIC,* 2009, 228-229
- **Y. TAKEUCHI et al.** An improved dual-conduction class-C VCO using a tail resistor. *IEEE EuMIC,* 2011, 204-207
- **M. TOHIDIAN et al.** High-swing class-C VCO. *IEEE ESSCIRC,* 2011, 495-498
- **J. CHEN et al.** A low power, start-up ensured and constant amplitude class-C VCO in 0.18mCMOS. *IEEE Microwave. Wireless Compon. Lett.,* Août 2011, vol. 21 (8), 427-429
- **WEI DENG et al.** Class-C VCO With Amplitude Feedback Loop for Robust Start-Up and Enhanced Oscillation Swing. *IEEE Journal of Solid-State Circuits,* Février 2013, vol. 48 (2), 429-440